# EUROPEAN PATENT APPLICATION

(11) **EP 0 597 603 A2**
(43) Date of publication of application: **18.05.1994**
(21) Application number: 93308495.6
(22) Date of filing: 25.10.1993
(51) Int. Cl.: H01L 21/76, H01L 21/321

(54) **Trench isolation planarization using a hard mask**

(30) Priority: 13.11.1992 US 975871
(71) Applicant: DIGITAL EQUIPMENT CORPORATION, Maynard, Massachusetts 01745 (US)
(72) Inventor: Grula, Gregory Joseph, Charlton, Massachusetts 01507 (US); Wang, Ching-Tai Sherman, Worcester, Massachusetts 01605 (US)
(74) Representative: Goodman, Christopher

(57) **Abstract**

An improved process for planarizing an isolation trench in the fabrication of a semiconductor chip involves replacing the photoresist material used for planarization with a hard mask film. The hard mask material must be able to gap fill ("planarize") narrow trenches which do not receive a planarization block mask (or "filler mask") to protect them during the subsequent hard mask film etch. The hard mask film is typically conformal over large features and thus will not be susceptible to pattern density effects. Using the hard mask material, all active areas/trenches appear the same after planarization, independent of pattern density. Further, the hard mask material may subsequently be polished so that there are no peaks or spikes and no depressions.

## Description

### Field Of The Invention

The present invention relates generally to manufacturing semiconductor devices, and more particularly, to a method of implementing trench isolation planarization in semiconductor substrates.

### Background Of The Invention

Many electronic integrated circuits, also known as "chips," are formed by a strategic placement and interconnection of selected electronic devices, such as transistors and the like, within a semiconductor substrate. The electronic devices are interconnected using an array of surface conductors carrying data signals through which the devices communicate. The electronic devices, however, must be sufficiently isolated from one another so that the signals in each respective electronic device do not interfere with and degrade the others' signal quality.

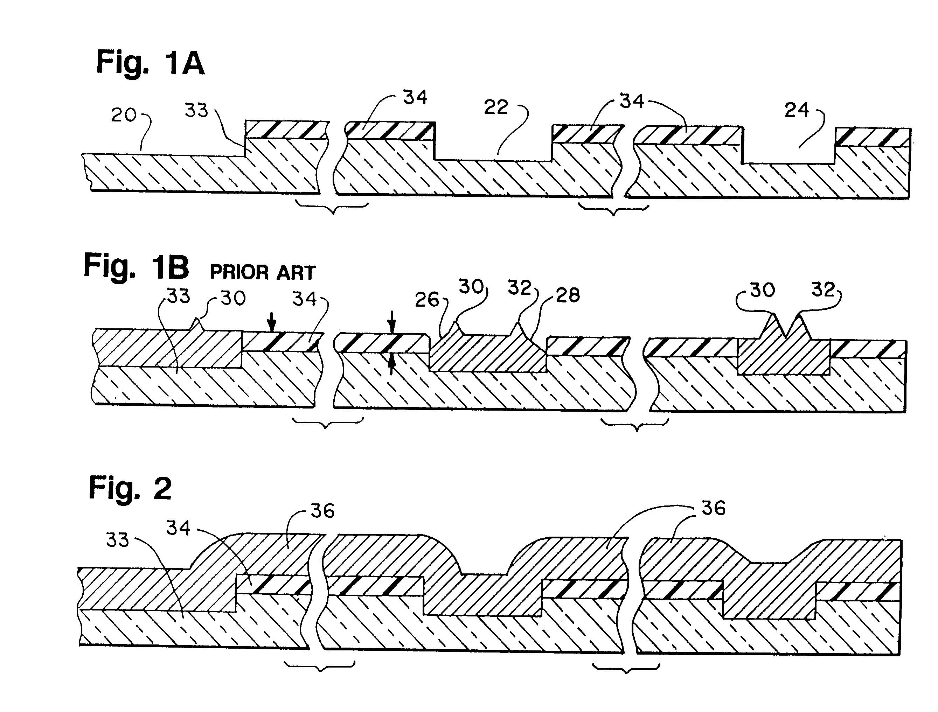

In semiconductor applications requiring relatively close placement of electronic devices, isolation is commonly provided by forming a recess (or "trench"), depicted as 20, 22 and 24 (Fig. 1a) between two active areas (or "area mesas") 33 (Fig. 1 a), upon which the electronic devices are located, and filling the trench with isolation material. Thus, the filled trench then provides isolation between the electronic devices and the surface conductors.

A major problem encountered in refining this recessing technique involves maintaining planarity in the trench so that materials, such as printed conductors, can be readily applied thereon using conventional methods (using, for instance, lithography). A poorly planarized trench typically includes uneven areas along the top of the trench such as oxide depressions and spikes (26, 28 and 30, 32 of Fig. 1 b). In applications requiring signal- carrying conductors to be printed on the filled trench, a poorly planarized trench causes signal discontinuities and often degrades the performance of the entire chip.

There have been numerous attempts to improve trench planarity in the prior art, each has fallen short of providing a trench that is adequately planarized for certain applications. Such processes are described, for example, in the background sections, and in the detailed description sections, of U.S. Patent Nos. 5,006,482 (Kerbaugh et al.), 5,007,234 (Scoopo et al.) and 4,892,614 (Chapman et al.).

In prior art planarization processes using resist etch back planarization (REB) to planarize isolation trenches, there exists a consistency problem with respect to the pattern density of the trenches. Because spun-on resist is typically dependent on pattern density, all trenches do not planarize to the same degree. For instance, active areas and/or trenches which have a thinner resist coating will end up being over-etched. This results in an oxide depression (such as 26, 28 of Fig. 1 b) next to the active are mesa. Those active areas/trenches which have a thicker resist will form an oxide spike (30, 32 of Fig. 1 b) in the trench next to the adjacent active area mesa (33 of Fig. 1 b).

Accordingly, there is a need for a improved process of fabricating an isolation trench, which overcomes the aforementioned deficiencies.

### Summary Of The Invention

The present invention provides an isolation trench arrangement and a process of fabricating an isolation trench in a semiconductor chip so as to overcome the aforementioned disadvantages of the prior art.

The invention in its broad form resides in a process of planarizing the isolation trench in semiconductor fabrication, as recited in claim 1. The invention also resides in a trench filling arrangement using the process of claim 1.

In one embodiment, the process involves replacing the photoresist material typically used for planarization with a hard mask material. The hard mask material must be able to gap fill ("planarize") narrow trenches which do not receive a planarization block mask (or "filler mask") to protect them during the subsequent hard mask film etch. The hard mask material is typically conformal over large features and thus will not be susceptible to pattern density effects. Defining the hard mask material with filler mask, all active areas/trenches appear the same after planarization, independent of pattern density.

In a preferred embodiment, the present invention provides an improved process for planarizing an isolation trench in the fabrication of a semiconductor chip using a layer of hard film over a dielectric layer. The isolation trench, which can be wide, narrow or of moderate width, typically has a top wall edge and a bottom and is adjacent to two sides having top surfaces thereon. The inventive planarization process includes: depositing a layer of dielectric material over and into the trench; depositing a layer of hard film over the layer of dielectric material to cover the dielectric material and the top surfaces of the sides; and etching back the layer of hard film and the layer of dielectric material until the hard film and the dielectric material are substantially removed from the top surfaces of the sides and until a small pocket of hard film remains over the trench. In this manner, the present invention provides an isolation trench process using a layer of hard film to prevent depressions from forming as a result of the etching.

In another embodiment of the present invention, a polish is used after the step of etching to remove any peaks or spikes that may remain. For example, a chemical mechanical polish may be used to remove the undesired peak areas.

In yet another embodiment of the present invention, the step of etching back the layer of hard film and the layer of dielectric material continues until a thin layer of dielectric covers the top surfaces of the sides. For example, the etching continues until the thin layer of dielectric is about 1000 Angstroms thin. Subsequently, the thin layer of dielectric material is removed, for example, by applying a chemical mechanical polish. This results in an isolation trench arrangement having no depressions and no peaks.

The above summaries exemplify some of the more important features described herein so that the detailed description thereof that follows may be better understood, and in order that the contribution to the art may be better appreciated.

### Brief Description Of The Drawings

A more detailed understanding of the invention may be had from the following description of preferred embodiments, given by way of example and to be understood in conjunction with the accompanying drawing wherein:
Fig. 1 a is a cross-sectional view of conventional trenches, of various widths, formed in a semiconductor substrate;
Fig. 1 b is a cross-sectional view of an isolation trench arrangement, which exemplifies the result of prior art planarization techniques;
Figs. 2-15 are cross-sectional views of the trenches of Fig. 1, illustrating various stages of an isolation trench planarization process, in accordance with embodiments of the present invention, and including three variations more particularly:
Figs. 2-6 illustrate a preferred set of planarization steps which are performed for each of the three variations,

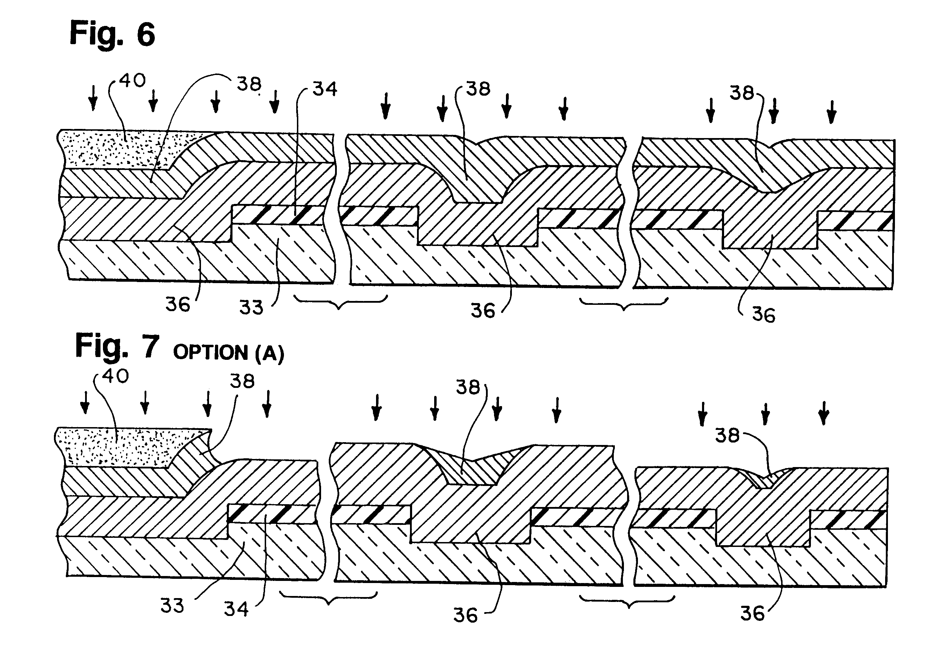

Figs. 7-9 illustrate a first set of steps performed after the steps corresponding to Figs. 2-6 so as to represent a first variation.

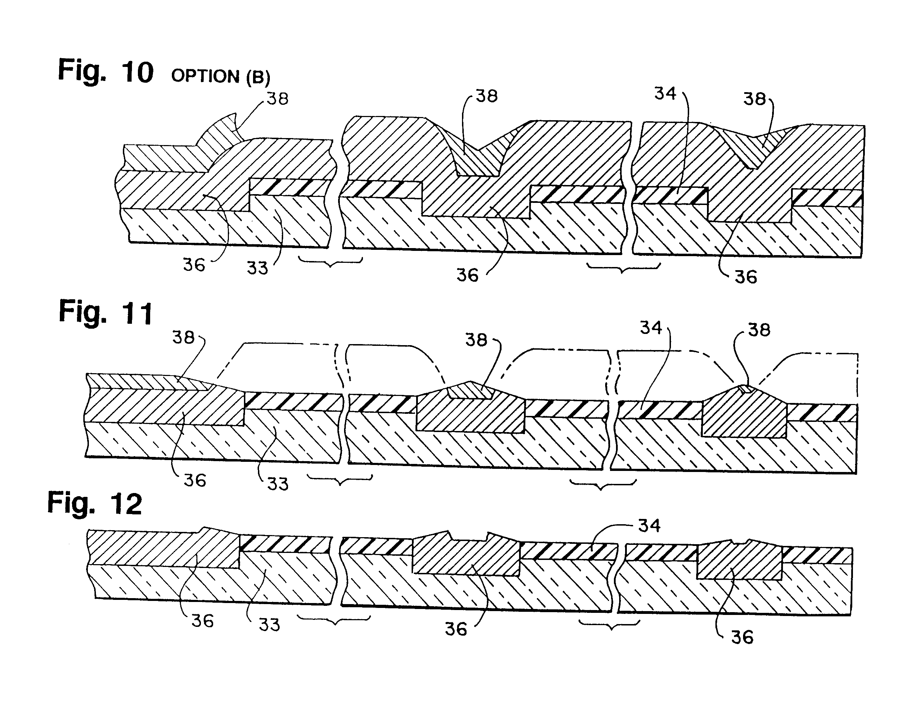

Figs. 10-12 illustrate a second set of steps performed after the steps corresponding to Figs. 2-6 so as to represent a second variation, and

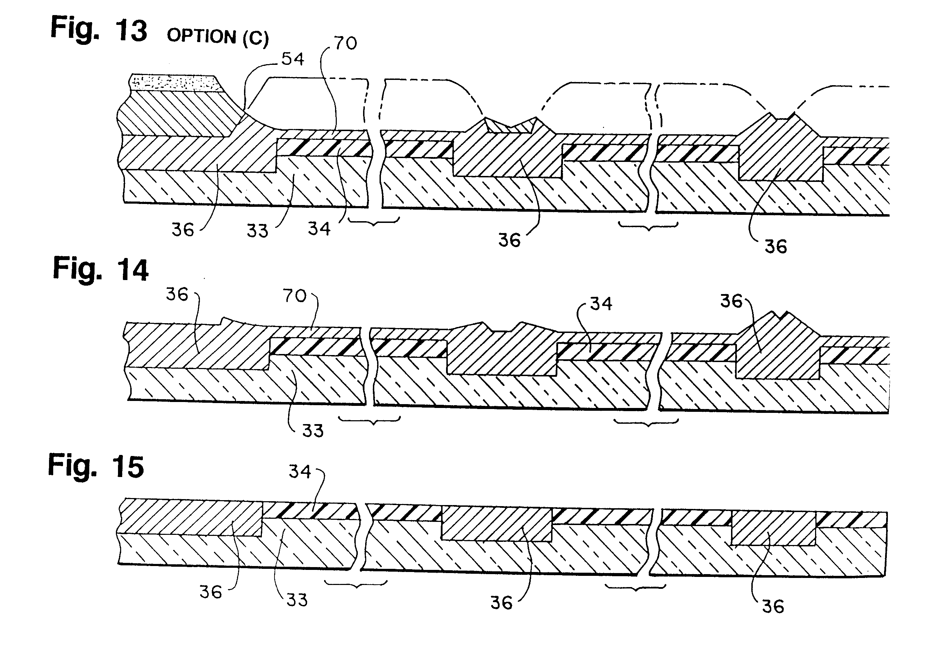

Figs. 13-15 illustrate a third set of steps performed after the steps corresponding to Figs. 2-6 so as to represent a third variation.

While the invention is susceptible to various modifications and alternative forms, specific embodiments thereof have been shown by way of example in the drawings and will be described in detail herein. It should be understood, however, that it is not intended to limit the invention to the particular forms disclosed. On the contrary, the intention is to cover all modifications, equivalents, and alternatives falling within the scope of the invention.

### Detailed Description Of The Preferred Embodiments

Turning now to Fig. 1 a, three conventionally formed trenches in a semiconductor substrate are illustrated to exemplify the wide variety of trench types for which the present invention is applicable. These trenches include a wide trench 20, a trench 22 of moderate width and a narrow trench 24. The moderately sized trench 22 may be, for example, on the order of about 0.6 micrometer tall by 1.75 micrometers wide, while the narrow trench 24 may be, for example, on the order of about 0.6 micrometer tall by 0.5 micrometer wide. Each isolation trench includes a pair of sides having top silicon surfaces 33 which can be used as electronic active areas of the semiconductor chip. The active areas 33 are covered by protective materials 34, e.g., first by oxide and then by nitride.

As previously mentioned, Fig. 1 b illustrates the final product of a planarization process implemented in accordance with the prior art. The final product is shown to include peaks (or spikes) 30, 32 protruding from the trench top, and slight depressions 26, 28 adjacent each side wall of the trench.

The present invention provides a planarization process which substantially eliminates the depressions (and spikes) and, therefore, the problems that ensue therefrom. According to one implementation of the present invention, a layer of dielectric 36, such as Tetra-ethyl-ortho-silicate ("TEOS"), is deposited over the semiconductor chip. This dielectric deposition is applied so that the trench (20, 22 or 24 of Fig. 1a) is substantially filled and the adjacent sides are adequately covered, as shown in Fig. 2. This step is well known to those practiced by the art. See U.S. Patent No. 5,007,234 (Scoopo et al.), assigned to the same assignee as the present invention.

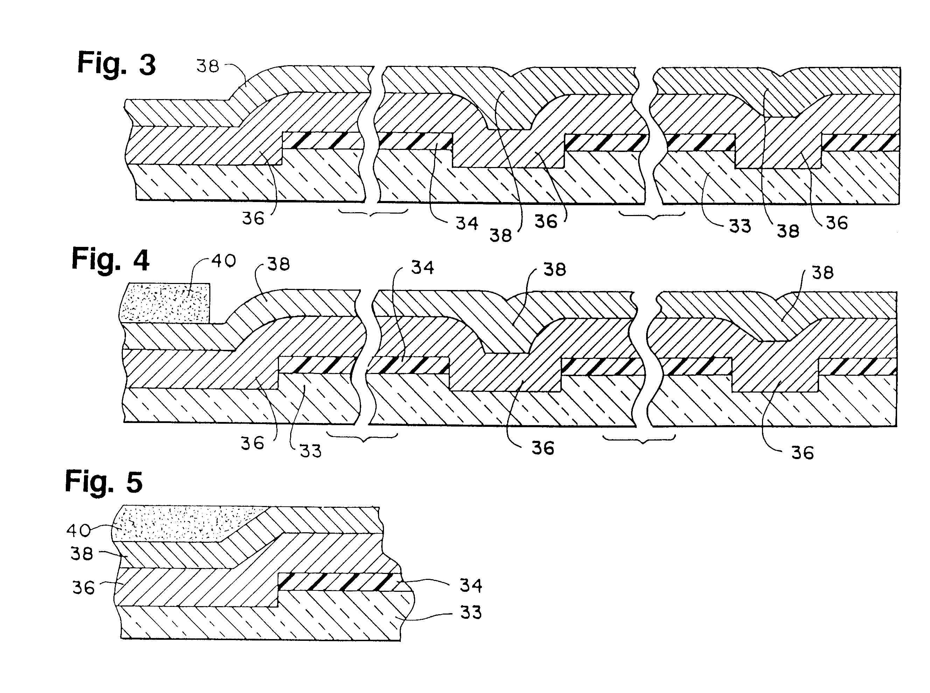

The next step, as illustrated in Fig. 3, involves depositing a layer of hard film material (or mask) 38 over the TEOS layer. Any of a number of hard films is suitable including, for example, nitride, polysilicon, Aluminum or Tungsten. The application of the hard film 38 is an important aspect of the inventive process, because the process uses the hard film to prevent the formation of the previously discussed depressions (26, 28 of Fig. 1 b) at the top of the filled trench.

If the trench being filled is a wide trench, such as trench 20 of Fig. 1 a, a conventional filler resist block (or plug) 40 (Fig. 4) is applied to compensate for, and provide protection to, the conformal characteristics of the hard film in the wide trench. As depicted in Fig. 5, the filler resist block 40 is reflowed, for example, using 180 degrees Centigrade heat for about seventy seconds, so as to fill the distance between the TEOS and the filler resist. Due to the gap-fill characteristics of the hard film for the narrowly sized trench and the moderately sized trench, these trenches do not use a filler resist block 40; however, for the moderately sized trench the hard film should be sufficiently thick to fill the gap or the hard film should be applied in a manner that results in a thin layer with no conformal dip over the center of the trench.

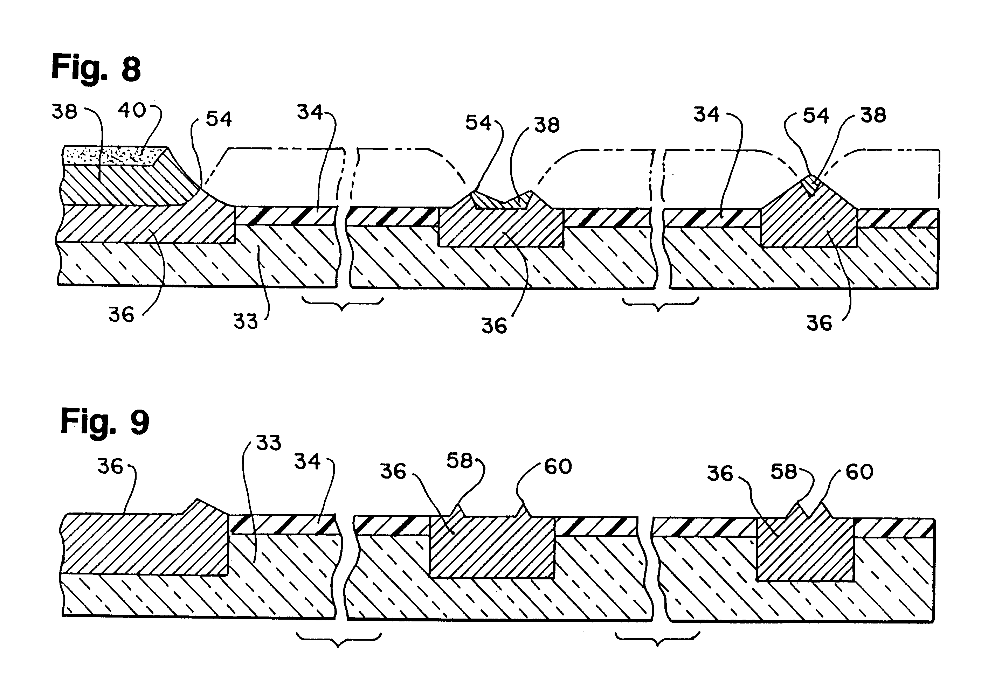

The next step in the process is shown in Fig. 6, where the step of etching back the layer of hard film 38 and the dielectric layer 36 begins. First, a hard-film etch, preferably a reactive ion etch (RIE) is applied (depicted by downwardly pointing arrows) over the semiconductor chip to remove the layer of hard film until the hard film is removed from the top surfaces of the sides. Because the hard film is thicker in the moderately-sized trench, a small pocket of hard film 38 (Fig. 7) remains over the trench and adjacent a peak 54 (Fig. 8). Examples of etch-source materials for etching a hard film, include a chlorine-based plasma type (such as CL₂) or a bromide-based plasma type (such as HBr) for a polysilicon material. For etching a hard material such as nitride, it may be possible to use a fluorine-based plasma type source material (such as SF₆). The hard-film RIE applied in connection with the step shown in Fig. 6 results in the trench filling arrangement of Fig. 7.

Figs. 7-9 illustrate the next steps in the process in accordance with the first of three variations. After the hard-film RIE of Fig. 6 is applied, a dielectric RIE is applied over the semiconductor chip to remove further the layer of dielectric material 36, as depicted in Fig. 7. Thus, in Fig. 8, a small pocket of hard film 38 remains adjacent a peak 54 of the dielectric material 36. The dashed lines illustrate the absence of the dielectric material 36 from its presence in Fig. 7.

Fig. 9 illustrates the resultant product from this first variation of the inventive process after the resist and hard film are removed, with no depression areas as a result of the hard-film layer extending above the trench. Although peaks 58, 60 are present, this is a significant improvement over the prior art arrangement of Fig. 1 which includes the undesirable depression areas.

Turning now to Figs. 10-12, a second variation is shown for completing the process set forth in connection with figures 1-6. Thus, from the step described in connection with Fig. 6, the next step (which pertains only to the wider trench) is to strip off the filler resist 40, as depicted in Fig. 10. The filler resist 40 may be stripped off using conventional methods, such as through the application of sulfuric acid plus hydrogen peroxide (H₂0₂).

The next step, as illustrated in Fig. 11, involves using chemical mechanical polish ("CMP"), or the like, to remove the dielectric layer 36 over the active area mesas 33 and to remove much of the hard mask 38, such that only a small pocket remains between adjacent peaks of the dielectric material 36 over the trench. The dotted lines in Fig. 11 outline the extent to which the dielectric layer 36 has been removed

Any of a number of suitable polishes may be used in connection with this step of the process. For example, one suitable chemical mechanical polisher is model No. 372 available from Westech Systems, Inc. of Phoenix, Arizona. For further information regarding use of chemical mechanical polishes, reference may be made to, "A New Planarization Technique Using a Combination of RIE and Chemical Mechanical Polish (CMP)," by B. Davari et. al., IEDM Technical Digest, 1990.

Finally, the hard film is stripped off, as shown in Fig. 12, using the appropriate solution. For example, if the hard mask is nitride, the stripping agent can be hot phosphoric acid, while a hard mask of polysilicon can employ a KOH solution as the stripping agent.

In Figs. 13-15, a third variation is shown for completing the process set forth in connection with figures 1-6. Thus, from the step described in connection with Fig. 6, the next step is similar to the step described in connection with Fig. 7, except that the etching (using dielectric RIE) of the dielectric layer 36 terminates when the thickness of the dielectric layer 36 over the active area mesas adjacent the trench is about 1000 Angstroms. This thickness of the dielectric layer 36 is depicted as 70 of Fig. 13. The dotted lines of Fig. 13 illustrate the extent to which the hard mask 38 and the dielectric material 36 has been removed as a result of the etching.

The next step is illustrated in Fig. 14, where the resist and hard film are stripped off using the appropriate solution, as was performed in connection with Fig. 12.

Finally, as with the step described in connection with Fig. 11, Fig. 15 involves using chemical mechanical polish ("CMP"), or the like. In this step, however, the polish is used to remove the remaining 1000 Angstroms of the dielectric layer 36, as shown in Fig. 15. As shown in Fig. 15 and unlike the results shown in Figs. 9 and 12, the final result of this third implementation of the present invention is a planarized trench having no peaks and no depressions.

Accordingly, the present invention provides an extremely accurate and consistent process of trench planarization, with three variations. The third variation, which provides a planarized trench having no peaks and no depressions, is preferred. While the inventive system has been particularly shown and described with reference to these various embodiments, it will be recognized by those skilled in the art that modifications and changes may be made to the present invention described herein.

## Claims

1. For use in the fabrication of a semiconductor chip including an isolation trench having a top wall edge and a bottom and being adjacent to two sides having top surfaces thereon, a process of planarizing the isolation trench comprising the steps of:
depositing a layer of dielectric material over and into the trench so as to fill the trench about to the top wall edge;
depositing a layer of hard film over the layer of dielectric material to cover the dielectric material and the top surfaces of the sides; and
etching back the layer of hard film and the layer of dielectric material until the hard film and the dielectric material are substantially removed from the top surfaces of the sides and until a small pocket of hard film remains over the trench.

2. A process of planarizing an isolation trench, according to claim 1, further including the step of polishing the small pocket of hard film and the dielectric material until any peak adjacent the hard film is considerably removed, wherein the step of polishing includes the step of applying a chemical mechanical polish.

3. A process of planarizing an isolation trench, according to claim 1, wherein the step of etching back the layer of hard film and the layer of dielectric material includes etching back the layer of hard film using a reactive ion hard-film etch, and includes etching back the layer of dielectric material using a reactive ion oxide- film etch.

4. A process of planarizing an isolation trench, according to claim 1, wherein the step of etching back the layer of hard film and the layer of dielectric material includes first etching back the layer of hard film using a reactive ion hard-film etch and then etching back the layer of dielectric material using a reactive ion oxide- film etch, and further includes the steps of stripping off excess material using a wet chemical and polishing the small pocket of hard film.

5. A process of planarizing an isolation trench, according to claim 1, wherein the step of etching back the layer of hard film and the layer of dielectric includes forming the small pocket of hard film to prevent a depression area from forming.

6. A process of planarizing an isolation trench, according to claim 1, wherein the step of etching back the layer of hard film and the layer of dielectric material continues until a thin layer of dielectric covers the top surfaces of the sides, wherein the step of etching back the layer of hard film and the layer of dielectric continues until the thin layer is about 1000 Angstroms thin.

7. For use in the fabrication of a semiconductor chip including an isolation trench having a top wall edge and a bottom and being adjacent to two sides having top surfaces thereon, a process of planarizing the isolation trench comprising the steps of:
depositing a layer of dielectric material over and into the trench;
depositing a layer of hard film over the layer of dielectric material to cover the dielectric material and the top surfaces of the sides;
etching back the layer of hard film and the layer of dielectric material until the hard film and the dielectric material are substantially removed from the top surfaces of the sides and until a small pocket of hard film remains over the trench and adjacent a peak of dielectric material, such that there is no depression formed adjacent the peak; and
polishing the small pocket of hard film until the peak is considerably removed.

8. A process of planarizing an isolation trench, according to claim 7, wherein the step of polishing includes the step of applying a chemical mechanical polish, wherein the step of etching back the layer of hard film and the layer of dielectric material continues until a thin layer of dielectric covers the top surfaces of the sides, further including removing the thin layer of dielectric, by applying a chemical mechanical polish.

9. A process of planarizing an isolation trench, according to claim 7, wherein the isolation trench is a wide trench and the process further includes the step of depositing a filler over the layer of hard film and above the trench before the step of etching back the layer of hard film and the layer of dielectric material, wherein the step of depositing a filler includes the step of reflowing the filler using a heating process.

10. For use in the fabrication of a semiconductor chip including an isolation trench having a top wall edge and a bottom and being adjacent to two sides having top surfaces thereon, a process of planarizing the isolation trench comprising the steps of:
depositing a layer of dielectric material over and into the trench;
depositing a layer of hard film over the layer of dielectric material to cover the dielectric material and the top surfaces of the sides;
etching back the layer of hard film and the layer of dielectric material until the hard film is removed from the top surfaces of the sides and until the dielectric material is removed from the top surfaces except for a thin layer of about 1000 Angstroms; and
applying chemical mechanical polish until substantially all the dielectric material is removed from the top surfaces and substantially all the hard film is removed.

11. A trench filling arrangement manufactured in accordance with the process of claim 10.
